(19) Europäisches Patentamt
European Patent Office
Office européen des brevets

(11) **EP 2 629 307 B1**

(12) **EUROPEAN PATENT SPECIFICATION**

(45) Date of publication and mention
of the grant of the patent:
**08.08.2018 Bulletin 2018/32**

(51) Int Cl.:
*H01B 5/14* (2006.01)     *B32B 7/02* (2006.01)
*B32B 9/00* (2006.01)     *G02F 1/1333* (2006.01)
*H01L 31/04* (2014.01)     *H01L 51/50* (2006.01)
*H05B 33/02* (2006.01)     *H05B 33/14* (2006.01)
*H05B 33/28* (2006.01)

(21) Application number: **11832593.5**

(22) Date of filing: **13.10.2011**

(86) International application number:
**PCT/JP2011/073543**

(87) International publication number:
**WO 2012/050161 (19.04.2012 Gazette 2012/16)**

(54) **TRANSPARENT ELECTRICALLY CONDUCTIVE FILM AND PROCESS FOR PRODUCTION THEREOF, MEMBER FOR ELECTRONIC DEVICE, AND ELECTRONIC DEVICE**

TRANSPARENTER ELEKTRISCH LEITENDER FILM UND VERFAHREN ZU SEINER HERSTELLUNG, ELEMENT FÜR EINE ELEKTRONISCHE VORRICHTUNG UND ELEKTRONISCHE VORRICHTUNG

FILM CONDUCTEUR DE L'ÉLECTRICITÉ TRANSPARENT ET SON PROCÉDÉ DE FABRICATION, ÉLÉMENT POUR DISPOSITIF ÉLECTRONIQUE ET DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.10.2010 JP 2010232328**

(43) Date of publication of application:
**21.08.2013 Bulletin 2013/34**

(73) Proprietor: **LINTEC Corporation**
**Tokyo 173-0001 (JP)**

(72) Inventors:
• **NAGAMOTO Koichi**
**Tokyo 173-0001 (JP)**
• **KONDO Takeshi**
**Tokyo 173-0001 (JP)**
• **NAGANAWA Satoshi**
**Tokyo 173-0001 (JP)**

(74) Representative: **Adam, Holger et al**
**Kraus & Weisert**
**Patentanwälte PartGmbB**
**Thomas-Wimmer-Ring 15**
**80539 München (DE)**

(56) References cited:
**EP-A1- 1 063 560     EP-A1- 2 397 324
WO-A1-2010/067857     WO-A1-2011/102198
JP-A- 2005 071 837     JP-A- 2008 041 640**

**Description**

TECHNICAL FIELD

The invention relates to a transparent conductive film, a method for producing the same, an electronic device member that includes the transparent conductive film, and an electronic device that includes the electronic device member.

BACKGROUND ART

In recent years, studies have been conducted to use a transparent plastic film as an electrode substrate instead of a glass plate for displays (e.g., liquid crystal display and electroluminescence (EL) display) in order to implement a reduction in thickness, a reduction in weight, an increase in flexibility, and the like. However, since a plastic film tends to allow water vapor, oxygen, and the like to pass through as compared with a glass plate, the elements of a display may easily deteriorate.

In order to solve the above problem, Patent Document 1 proposes a flexible display substrate in which a transparent gas barrier layer formed of a metal oxide is stacked on a transparent plastic film. However, since the transparent gas barrier layer formed of a metal oxide is stacked on the surface of the transparent plastic film by evaporation (deposition), ion plating, sputtering, or the like, cracks may occur in the gas barrier layer when the substrate is rolled up or bent, and the gas barrier capability may deteriorate.

A transparent conductive film in which a transparent conductive layer is provided on a transparent plastic substrate has been known. Tin-doped indium oxide (ITO) has been mainly used as a material for forming the transparent conductive layer of the transparent conductive film. However, since indium is a trace metal, a zinc oxide-based conductive material has been proposed as a transparent conductive material that may substitute ITO. However, the zinc oxide-based conductive material has a problem in that a deterioration in sheet resistance easily occurs under high-temperature/high-humidity conditions as compared with ITO.

In order to solve the above problem, Patent Document 2 discloses a transparent conductor in which a silicon-doped zinc oxide film is formed on a hard coat layer provided on a plastic substrate. However, the transparent conductor disclosed in Patent Document 2 may show a deterioration in conductivity due to a decrease in crystallinity of the conductive material.

Patent Document 3 discloses a transparent heating element that includes a transparent conductive film of which the heat resistance is improved by adding a specific amount of gallium to zinc, for example. However, since it is necessary to add gallium to zinc under special conditions when forming the transparent conductive film of the transparent heating element disclosed in Patent Document 3, the production conditions are limited.

Patent Document 4 discloses a substrate that is provided with a transparent conductive film, and exhibits improved heat resistance as a result of providing a heat-resistant conductive layer having a high degree of oxidation. However, the substrate disclosed in Patent Document 4 has a problem in that it is difficult to control the sheet resistance of the transparent conductive layer under a high-temperature/high-humidity environment.

Non-patent Document 1 discloses a technique that controls the sheet resistance of a transparent conductive layer of a gallium oxide-zinc oxide-based transparent conductor under a high-temperature/high-humidity environment by increasing the amount of doping with gallium oxide, and setting the thickness of the transparent conductive layer to 400 nm. However, since it is necessary to deposit a transparent conductor to a thickness of 400 nm, the productivity significantly deteriorates. Moreover, since a large amount of gallium oxide is used for doping, it is difficult to employ the technique disclosed in Non-patent Document 1 from the viewpoint of raw material cost.

RELATED-ART DOCUMENT

PATENT DOCUMENT

Patent Document 1: JP-A-2000-338901
Patent Document 2: JP-A-8-45352
Patent Document 3: JP-A- 6-187833
Patent Document 4: JP-A-2009-199812

NON-PATENT DOCUMENT

Non-patent Document 1: APPLIED PHYSICS LETTERS 89, 091904 (2006)

SUMMARY OF THE INVENTION

TECHNICAL PROBLEM

The invention was conceived in view of the above situation. An object of the invention is to provide a transparent conductive film that exhibits an excellent gas barrier capability and excellent transparency, and has low sheet resistance (i.e., exhibits excellent conductivity) even under a high-temperature/high-humidity environment, a method for producing the same, an electronic device member that includes the transparent conductive film, and an electronic device that includes the electronic device member.

SOLUTION TO PROBLEM

The inventors of the invention conducted extensive studies in order to achieve the above object. As a result, the inventors found that a transparent conductive film that includes a base layer, a gas barrier layer, and a transparent conductive layer, the gas barrier layer being formed of a material that includes silicon atoms, oxygen atoms, and carbon atoms, the silicon atom content rate, the oxygen atom content rate, and the carbon atom content rate in the surface layer part of the gas barrier layer being within specific ranges, and the transparent conductive film having a water vapor transmission rate at a temperature of 40°C and a relative humidity of 90% of 6.0 g/m$^2$/day or less, and a visible light transmittance at a wavelength of 550 nm of 90% or more, exhibits an excellent gas barrier capability and excellent transparency, and has low sheet resistance (i.e., exhibits excellent conductivity) even under a high-temperature/high-humidity environment. The inventors also found that the gas barrier layer of such a transparent conductive film can be easily and efficiently formed by implanting ions into a layer that includes a hydrolysis/dehydration condensation product of a tetrafunctional organosilane compound (e.g., tetraethoxysilane). These findings have led to the completion of the invention.

Several aspects of the invention provide the following transparent conductive film (see (1) to (6)), method for producing a transparent conductive film (see (7) to (10)), electronic device member (see (11)), and electronic device (see (12)).

(1) A transparent conductive film including a base layer, a gas barrier layer, and a transparent conductive layer, the gas barrier layer being formed of a material that includes silicon atoms, oxygen atoms, and carbon atoms, a silicon atom content rate, an oxygen atom content rate, and a carbon atom content rate in a surface layer part of the gas barrier layer determined by XPS elemental analysis being 18.0 to 28.0%, 48.0 to 66.0%, and 10.0 to 28.0%, respectively, based on a total content rate (=100 atom%) of silicon atoms, oxygen atoms, and carbon atoms, wherein the gas barrier layer is a layer obtained by implanting ions into a layer that includes a hydrolysis/dehydration condensation product of a tetrafunctional organosilane compound, and
the transparent conductive film having a water vapor transmission rate at a temperature of 40°C and a relative humidity of 90% of 6.0 g/m$^2$/day or less, and a visible light transmittance at a wavelength of 550 nm of 90% or more.
(2) The transparent conductive film according to (1), wherein the ions are obtained by ionizing at least one gas selected from a group consisting of hydrogen, oxygen, nitrogen, argon, helium, xenon, krypton, a silicon compound, and a hydrocarbon.
(3) The transparent conductive film according to (1), wherein the gas barrier layer is a layer obtained by implanting ions into a layer that includes a hydrolysis/dehydration condensation product of a tetrafunctional organosilane compound by a plasma ion implantation method.
(4) The transparent conductive film according to any one of (1) to (3), wherein the tetrafunctional organosilane compound is a tetra(C$_1$-C$_{10}$)alkoxysilane.
(5) The transparent conductive film according to (1), wherein the transparent conductive layer is formed of a conductive metal oxide.
(6) The transparent conductive film according to (5), wherein the conductive metal oxide is a zinc-based oxide.
(7) A method for producing the transparent conductive film according to any one of (1) to (6), the method including implanting ions into a layer that forms a surface of a formed body and includes a hydrolysis/dehydration condensation product of a tetrafunctional organosilane compound.
(8) The method according to (7), wherein the ions are obtained by ionizing at least one gas selected from a group consisting of hydrogen, oxygen, nitrogen, argon, helium, xenon, krypton, a silicon compound, and a hydrocarbon.
(9) The method according to (7), wherein the ions are implanted by a plasma ion implantation method.

(10) An electronic device member including the transparent conductive film according to any one of (1) to (6).

(11) An electronic device including the electronic device member according to (10).

ADVANTAGEOUS EFFECTS OF THE INVENTION

The transparent conductive film according to one aspect of the invention exhibits an excellent gas barrier capability and excellent transparency, and has low sheet resistance (i.e., exhibits excellent conductivity) even under a high-temperature/high-humidity environment.

Therefore, the transparent conductive film may suitably be used as an electronic device member (e.g., solar battery backsheet) for flexible displays, solar cells, and the like.

The method for producing the transparent conductive film according to one aspect of the invention can easily and efficiently produce a transparent conductive film that exhibits an excellent gas barrier capability and excellent transparency, and maintains low sheet resistance (does not show a change in sheet resistance) (i.e., exhibits excellent conductivity) even under a high-temperature/high-humidity environment. The method can also inexpensively and easily achieve an increase in area of the transparent conductive film as compared with the case of forming an inorganic film.

Since the electronic device member according to one aspect of the invention exhibits an excellent gas barrier capability and excellent transparency, and has low sheet resistance (i.e., exhibits excellent conductivity) even under a high-temperature/high-humidity environment, the electronic device member may suitably be used for electronic devices such as a display and a solar cell.

BRIEF DESCRIPTION OF DRAWINGS

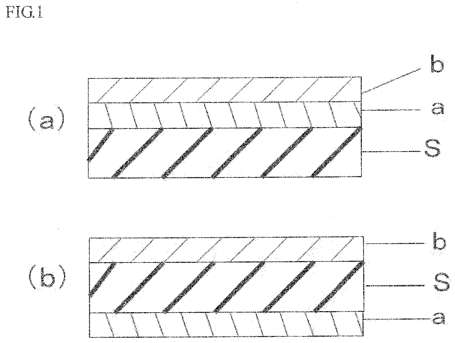

FIG. 1 is a view illustrating the layer configuration of a transparent conductive film according to one embodiment of the invention.

DESCRIPTION OF EMBODIMENTS

A transparent conductive film, a method for producing a transparent conductive film, an electronic device member, and an electronic device according to several embodiments of the invention are described in detail in below.

1) Transparent conductive film

A transparent conductive film according to one embodiment of the invention includes a base layer, a gas barrier layer, and a transparent conductive layer, the gas barrier layer being formed of a material that includes silicon atoms, oxygen atoms, and carbon atoms, the silicon atom content rate, the oxygen atom content rate, and the carbon atom content rate in a surface layer part of the gas barrier layer determined by XPS elemental analysis being 18.0 to 28.0%, 48.0 to 66.0%, and 10.0 to 28.0%, respectively, based on the total content rate (=100 atom%) of silicon atoms, oxygen atoms, and carbon atoms, and the transparent conductive film having a water vapor transmission rate at a temperature of 40°C and a relative humidity of 90% of 6.0 g/m$^2$/day or less, and a visible light transmittance at a wavelength of 550 nm of 90% or more.

The gas barrier layer of the transparent conductive film according to one embodiment of the invention may be a layer obtained by implanting ions into a layer that includes the hydrolysis/dehydration condensation product of a tetrafunctional organosilane compound (hereinafter may be referred to as "silicate layer").

Base layer

The transparent conductive film according to one embodiment of the invention includes the base layer. A material for forming the base layer is not particularly limited as long as the material is suitable for the intended use of the transparent conductive film. Examples of the material for forming the base layer include synthetic resins such as polyimides, polyamides, polyamideimides, polyphenylene ethers, polyetherketones, polyether ether ketones, polyolefins, polyesters, polycarbonates, polysulfones, polyether sulfones, polyphenylene sulfides, polyallylates, acrylic resins, cycloolefin polymers, and aromatic polymers.

Among these, polyesters, polyamides, polysulfones, polyether sulfones, polyphenylene sulfides, polyallylates, and cycloolefin polymers are preferable due to excellent transparency and versatility. It is more preferable to use polyesters or cycloolefin polymers.

Examples of the polyesters include polyethylene terephthalate, polybuthylene terephthalate, polyethylene naphthalate, polyallylates, and the like.

Examples of the polyamides include wholly aromatic polyamides, nylon 6, nylon 66, nylon copolymers, and the like.

Examples of the cycloolefin polymers include norbornene polymers, monocyclic olefin polymers, cyclic conjugated diene polymers, vinyl alicyclic hydrocarbon polymers, and hydrogenated products thereof. Specific examples of the cycloolefin polymers include APEL (ethylene-cycloolefin copolymer manufactured by Mitsui Chemicals Inc.), ARTON (norbornene polymer manufactured by JSR Corporation), ZEONOR (norbornene polymer manufactured by Zeon Corporation), and the like.

The thickness of the base layer is not particularly limited, and may be determined depending on the intended use of the transparent conductive film. The thickness of the base layer is normally 0.5 to 500 $\mu$m, and preferably 10 to 250 $\mu$m.

Gas barrier layer

The surface layer part of the gas barrier layer of the transparent conductive film according to one embodiment of the invention includes silicon atoms, oxygen atoms, and carbon atoms within the above ranges.

Note that the term "surface layer part" used herein in connection with the gas barrier layer refers to an area of the gas barrier layer up to a depth of 15 nm from the surface of the gas barrier layer. The term "surface" used herein in connection with the gas barrier layer is intended to include the interface (boundary surface) with another layer.

The silicon atom content rate, the oxygen atom content rate, and the carbon atom content rate in the surface layer part of the gas barrier layer of the transparent conductive film according to one embodiment of the invention determined by XPS elemental analysis are 18.0 to 28.0% (preferably 19.0 to 26.0%), 48.0 to 66.0% (preferably 50.0 to 64.0%), and 10.0 to 28.0% (preferably 12.0 to 28.0%), respectively, based on the total content rate (=100 atom%) of silicon atoms, oxygen atoms, and carbon atoms.

A gas barrier layer in which the silicon atom content rate, the oxygen atom content rate, and the carbon atom content rate in the surface layer part are within the above ranges, may be formed by subjecting a layer that includes a hydrolysis/dehydration condensation product of a tetrafunctional organosilane compound to a plasma treatment, or implanting ions into a layer that includes a hydrolysis/dehydration condensation product of a tetrafunctional organosilane compound.

It is preferable that the gas barrier layer of the transparent conductive film according to one embodiment of the invention be a layer obtained by implanting ions into a silicate layer.

The term "silicate layer" used herein refers to a layer that includes a hydrolysis/dehydration condensation product of a tetrafunctional organosilane compound. The content of the hydrolysis/dehydration condensation product of the tetrafunctional organosilane compound in the silicate layer is preferably 50 wt% or more, and more preferably 70 wt% or more, from the viewpoint of obtaining an ion-implanted layer that exhibits an excellent gas barrier capability and excellent transparency.

The tetrafunctional organosilane compound used in connection with the embodiments of the invention is a compound in which four hydrolyzable groups are bonded to a silicon atom, and is represented by the following formula (A): $SiX_4$.

X in the formula (A) represent a hydrolyzable substituent, and may be either identical or different.

Examples of the substituent represented by X include a group shown by OR (wherein R represents a hydrocarbon group having 1 to 10 carbon atoms or an alkoxy group having 1 to 10 carbon atoms), a group represented by $OSi(R^a)(R^b)(R^c)$ (wherein $R^a$, $R^b$, and $R^c$ independently represent a hydrogen atom, an alkyl group having 1 to 10 carbon atoms, or a phenyl group), a halogen atom, and the like.

Specific examples of the group represented by OR include alkoxy groups having 1 to 10 carbon atoms, such as a methoxy group, an ethoxy group, a propoxy group, an isopropoxy group, a butoxy group, an isobutoxy group, a t-butoxy group, a pentyloxy group, and a hexyloxy group; alkoxyalkoxy group having 2 to 10 carbon atoms, such as a methoxymethoxy group, an ethoxymethoxy group, and an ethoxyethoxy group; and the like.

Specific examples of the group represented by $OSi(R^a)(R^b)(R^c)$ include a silyloxy group, a trimethylsilyloxy group, a triethylsilyloxy group, a phenyldimethylsilyloxy group, a t-butyldimethylsilyloxy group, and the like.

Examples of the halogen atom include a chlorine atom, a bromine atom, and the like.

Specific examples of the tetrafunctional organosilane compound include tetra($C_1$-$C_{10}$)alkoxysilanes such as tetramethoxysilane, tetraethoxysilane, tetrapropoxysilane, tetraisopropoxysilane, and tetrabutoxysilane; tri($C_1$-$C_{10}$)alkoxyhalogenosilanes such as trimethoxychlorosilane; triethoxychlorosilane, and tripropoxychlorosilane; di($C_1$-$C_{10}$)dihalogenoalkoxysilanes such as dimethoxydichlorosilane, diethoxydichlorosilane, and dipropoxydichlorosilane; mono($C_1$-$C_{10}$)alkoxytrihalogenosilanes such as methoxytrichlorosilane, ethoxytrichlorosilane, and propoxytrichlorosilane; and tetrahalogenosilanes such as tetrachlorosilane and tetrabromosilane. Note that the expression "($C_1$-$C_{10}$)" means that the number of carbon atoms is 1 to 10.

These tetrafunctional organosilane compounds may be used either alone or in combination.

It is preferable to use tetra($C_1$-$C_{10}$)alkoxysilanes due to an excellent handling capability and a capability to form a layer that exhibits an excellent gas barrier capability and excellent transparency.

The hydrolysis/dehydration condensation product of the tetrafunctional organosilane compound may be obtained by subjecting the tetrafunctional organosilane compound to hydrolysis/dehydration condensation in an appropriate solvent in the presence of water and an optional catalyst.

The amount of water is determined so that the ratio of the molar equivalent of water ($H_2O$) to the molar equivalent of the hydrolyzable group (X) (i.e., the molar ratio "$[H_2O]/[X]$") is preferably 1.0 or more, and more preferably 1.0 to 5.0. If the molar ratio "$[H_2O]/[X]$" is less than 1.0, the amount of unreacted hydrolyzable group may increase, and the refractive index of the resulting cured film may increase. If the molar ratio "$[H_2O]/[X]$" exceeds 5.0, the condensation reaction may proceed to an excessive extent, and gelation may occur.

The catalyst is not particularly limited. An acidic catalyst or a basic catalyst may be used as the catalyst.

Examples of the acidic catalyst include organic acids such as acetic acid, chloroacetic acid, citric acid, benzoic acid, dimethylmalonic acid, formic acid, propionic acid, glutaric acid, glycolic acid, maleic acid, malonic acid, toluenesulfonic acid, and oxalic acid; inorganic acids such as hydrochloric acid, nitric acid, sulfuric acid, phosphoric acid, and halogenated silanes; acidic sol fillers such as acidic colloidal silica and titania sol; and the like. These acidic catalysts may be used either alone or in combination.

Examples of the basic catalyst include alkali metal hydroxides such as sodium hydroxide and potassium hydroxide; alkaline-earth metal hydroxides such as calcium hydroxide; aqueous ammonia; amines such as triethylamine, diisopropylethylamine, and pyridine; and the like. These basic catalysts may be used either alone or in combination.

It is preferable to use the acidic catalyst from the viewpoint of reducing the production time.

The tetrafunctional organosilane compound may be subjected to hydrolysis/dehydration condensation while optionally heating the reaction system. In particular, the amount of unreacted hydrolyzable group can be infinitely reduced by promoting the hydrolysis reaction at 40 to 100°C over 2 to 100 hours. If the tetrafunctional organosilane compound is hydrolyzed under conditions outside the above temperature range and/or time range, the hydrolyzable group may remain unreacted.

The weight average molecular weight of the hydrolysis/dehydration condensation product of the tetrafunctional organosilane compound is not particularly limited, but is preferably 200 to 50,000, and more preferably 200 to 10,000, in order to obtain a silicate layer that also exhibits high mechanical strength. If the weight average molecular weight of the hydrolysis/dehydration condensation product is less than 200, the film-forming capability may deteriorate. If the weight average molecular weight of the hydrolysis/dehydration condensation product exceeds 50,000, the mechanical strength of the cured film may deteriorate.

The silicate layer may include an additional component other than the hydrolysis/dehydration condensation product of the tetrafunctional organosilane compound as long as the object of the invention is not impaired. Examples of the additional component include an additional polymer, a curing agent, an aging preventive, a light stabilizer, a flame retardant, a filler, a pigment, a leveling agent, an antifoaming agent, an antistatic agent, a UV absorber, a pH-adjusting agent, a dispersant, a surface modifier, a plasticizer, a siccative, an antirunning agent, and the like.

The silicate layer may be formed by an arbitrary method. For example, the silicate layer may be formed by applying a silicate layer-forming solution to the base layer using a known coating method, and appropriately drying the resulting film.

Examples of the silicate layer-forming solution include (a) a solution that includes the tetrafunctional organosilane compound, water, a catalyst, a solvent, and an optional additional component, (b) a solution that includes a (partial) hydrolyzate of the tetrafunctional organosilane compound, water, a catalyst, a solvent, and an optional additional component, (c) a solution that includes a hydrolysis/(partial) dehydration condensation product of the tetrafunctional organosilane compound, water, a catalyst, a solvent, and an optional additional component, and the like.

It is preferable to use a solvent that stably dissolves the tetrafunctional organosilane compound, the (partial) hydrolyzate of the tetrafunctional organosilane compound, or the hydrolysis/(partial) dehydration condensation product of the tetrafunctional organosilane compound.

Examples of such a solvent include xylene, toluene, esters such as butyl carbitol acetate, n-butyl acetate, and ethyl acetate, glycol ethers such as cellosolve and cellosolve acetate, ketones such as acetone and methyl ethyl ketone, a mixed solvent of two or more compounds among these compounds, and the like.

The content of the solvent in the silicate layer-forming solution is determined depending on the coating method, the type of the tetrafunctional organosilane compound, and the like, but is normally 5 to 99 mass%, and preferably 5 to 60 mass%.

A spin coater, a knife coater, a gravure coater, or the like may be used to apply the silicate layer-forming solution.

It is preferable to heat the resulting film in order to dry the film and improve the gas barrier capability of the resulting transparent conductive film. In this case, the film is heated at 80 to 150°C for several tens of seconds to several tens of minutes.

The hydrolysis/dehydration condensation reaction of the tetrafunctional organosilane compound, the (partial) hydrolyzate of the tetrafunctional organosilane compound, or the hydrolysis/(partial) dehydration condensation product of the tetrafunctional organosilane compound proceeds sufficiently as a result of heating the film, so that a high-quality cured film can be formed.

The thickness of the silicate layer is not particularly limited, but is normally 20 nm to 100 $\mu$m, preferably 30 nm to 500 nm, and more preferably 40 nm to 200 nm.

According to the embodiments of the invention, a transparent conductive film that exhibits a sufficient gas barrier capability can be obtained even if the silicate layer has a thickness at a nanometer level.

Examples of the ions to be implanted include ions of a rare gas (e.g., argon, helium, neon, krypton, and xenon), a fluorocarbon, hydrogen, nitrogen, oxygen, carbon dioxide, chlorine, fluorine, sulfur, a silicon compound, and a hydrocarbon; ions of a metal (e.g., gold, silver, copper, platinum, nickel, palladium, chromium, titanium, molybdenum, niobium, tantalum, tungsten, and aluminum); and the like.

Among these, ions obtained by ionizing at least one gas selected from the group consisting of hydrogen, nitrogen, oxygen, argon, helium, neon, xenon, krypton, a silicon compound, and a hydrocarbon are preferable due to ease of implantation and a capability to form an ion-implanted layer that exhibits an excellent gas barrier capability and excellent transparency.

Examples of the silicon compound include silane ($SiH_4$) and organosilicon compounds.

Examples of the organosilicon compounds include tetraalkoxysilanes such as tetramethoxysilane, tetraethoxysilane, tetra-n-propoxysilane, tetraisopropoxysilane, tetra-n-butoxysilane, and tetra-t-butoxysilane; substituted or unsubstituted alkylalkoxysilanes such as dimethyldimethoxysilane, dimethyldiethoxysilane, diethyldimethoxysilane, methyltriethoxysilane, ethyltrimethoxysilane, and (3,3,3-trifluoropropyl)trimethoxysilane;

arylalkoxysilanes such as diphenyldimethoxysilane and phenyltriethoxysilane; disiloxanes such as hexamethyldisiloxane (HMDSO); aminosilanes such as bis(dimethylamino)dimethylsilane, bis(dimethylamino)methylvinylsilane, bis(ethylamino)dimethylsilane, diethylaminotrimethylsilane, dimethylaminodimethylsilane, tetrakisdimethylaminosilane, and tris(dimethylamino)silane; silazanes such as hexamethyldisilazane, hexamethylcyclotrisilazane, heptamethyldisilazane, nonamethyltrisilazane, octamethylcyclotetrasilazane, and tetramethyldisilazane; cyanatosilanes such as tetraisocyanatosilane; halogenosilanes such as triethoxyfluorosilane; alkenylsilanes such as diallyldimethylsilane and allyltrimethylsilane; substituted or unsubstituted alkylsilanes such as di-t-butylsilane, 1,3-disilabutane, bis(trimethylsilyl)methane, trimethylsilane, tetramethylsilane, tris(trimethylsilyl)methane, tris(trimethylsilyl)silane, and benzyltrimethylsilane; silylalkynes such as bis(trimethylsilyl)acetylene, trimethylsilylacetylene, and 1-(trimethylsilyl)-1-propyne;

silylalkenes such as 1,4-bistrimethylsilyl-1,3-butadiyne and cyclopentadienyltrimethylsilane; arylalkylsilanes such as phenyldimethylsilane and phenyltrimethylsilane; alkynylalkylsilanes such as propargyltrimethylsilane; alkenylalkylsilanes such as vinyltrimethylsilane; disilanes such as hexamethyldisilane; siloxanes such as octamethylcyclotetrasiloxane, tetramethylcyclotetrasiloxane, and hexamethylcyclotetrasiloxane; N,O-bis(trimethylsilyl)acetamide; bis(trimethylsilyl)carbodiimide; and the like.

Examples of the hydrocarbon include alkanes such as methane, ethane, propane, butane, pentane, and hexane; alkenes such as ethylene, propylene, butene, and pentene; alkadienes such as pentadiene and butadiene; alkynes such as acetylene and methylacetylene; aromatic hydrocarbons such as benzene, toluene, xylene, indene, naphthalene, and phenanthrene; cycloalkanes such as cyclopropane and cyclohexane; cycloalkenes such as cyclopentene and cyclohexene; and the like.

These compounds (ions) may be used either alone or in combination.

The dose may be appropriately determined depending on the intended use of the transparent conductive film (e.g., gas barrier capability and transparency), and the like.

Ions may be implanted by applying ions (ion beams) accelerated by applying an electric field, or may be implanted by implanting ions present in plasma (plasma ion implantation method), for example. It is preferable to use the plasma ion implantation method since a transparent conductive film that exhibits an excellent gas barrier capability and the like can be easily obtained.

The plasma ion implantation method may be implemented by generating plasma in an atmosphere containing a plasma-generating gas, and implanting ions (cations) present in the plasma into the surface area of the ion implantation target layer by applying a negative high voltage pulse to the ion implantation target layer, for example.

The thickness of the ion implantation target area may be controlled by adjusting the implantation conditions (e.g., type of ions, applied voltage, and implantation time), and may be determined depending on the thickness of the ion implantation target layer, the intended use of the transparent conductive film, and the like. The thickness of the ion implantation target area is normally 10 to 1000 nm.

Whether or not ions have been implanted may be determined by performing elemental analysis on an area up to a depth of about 10 nm from the surface using X-ray photoelectron spectroscopy (XPS).

Transparent conductive layer

The transparent conductive film according to one embodiment of the invention includes the transparent conductive layer.

The gas barrier film can function as an electrode as a result of providing the transparent conductive layer. Therefore, the resulting transparent conductive film may suitably be used for an organic EL display device and the like.

A material for forming the transparent conductive layer is not particularly limited as long as the transparent conductive layer has a visible light transmittance at a wavelength of 550 nm of 90% or more. Examples of the material for forming the transparent conductive layer include metals such as platinum, gold, silver, and copper; carbon materials such as graphene and carbon nanotubes; organic conductive materials such as polyaniline, polyacetylene, polythiophene, polyparaphenylenevinylene, polyethylene dioxythiophene, and polypyrrole; inorganic conductive substances such as copper iodide and copper sulfide; non-oxide compounds such as chalcogenide, lanthanum hexaboride, titanium nitride, and titanium carbide; conductive metal oxides such as zinc oxide, zinc dioxide, gallium-doped zinc oxide, aluminum-doped zinc oxide, zinc oxide-doped indium oxide (IZO (registered trademark)), tin oxide, indium oxide, cadmium oxide, tin-doped indium oxide (ITO), indium gallium zinc oxide (IGZO), fluorine-doped indium oxide, antimony-doped tin oxide, and fluorine-doped tin oxide (FTO); and the like.

A dopant such as iodine, arsenic pentafluoride, an alkali metal, a polyanion of a poly(styrenesulfonate) may be added to the organic conductive material. Specific examples of the dopant include polyethylene dioxythiophene ("CLEVIOS P AI 4083" manufactured by H.C. Starck-V Tech Ltd.).

It is preferable to use a conductive metal oxide as the material for forming the transparent conductive layer since a transparent conductive film that exhibits excellent conductivity and excellent transparency can be easily obtained. It is more preferable to use an indium-based oxide that contains indium oxide as the main component (e.g., zinc oxide-doped indium oxide (IZO (registered trademark)), indium oxide, tin-doped indium oxide (ITO), indium gallium zinc oxide (IGZO), or fluorine-doped indium oxide), a zinc-based oxide that contains zinc oxide as the main component (e.g., zinc oxide, zinc dioxide, gallium-doped zinc oxide, or aluminum-doped zinc oxide), or a tin-based oxide that contains tin oxide as the main component (e.g., tin oxide, antimony-doped tin oxide, or fluorine-doped tin oxide (FTO)). It is still more preferable to use an indium-based oxide or a zinc-based oxide. It is particularly preferable to use a zinc-based oxide.

It is preferable that the indium oxide content in the indium-based oxide and the zinc oxide content in the zinc-based oxide be 90 mass% or more.

The component other than the main component is not particularly limited. Examples of the component other than the main component include aluminum, boron, gallium, silicon, tin, germanium, antimony, iridium, rhenium, cerium, zirconium, scandium, yttrium, zinc, indium, and oxides thereof. These elements or oxides thereof are added to reduce the resistivity of the conductive layer, for example. These elements or oxides thereof may be used either alone or in combination. The content of the component other than the main component in the transparent conductive layer is preferably 0.05 to 10 mass% from the viewpoint of the balance between conductivity and crystallinity.

The transparent conductive layer may be formed by a known method. For example, the transparent conductive layer may be formed by sputtering, ion plating, vacuum deposition, chemical vapor deposition, application using a bar coater or a micro gravure coater, or the like. It is preferable to form the transparent conductive layer by sputtering since the transparent conductive layer can be easily formed.

A surface on which the transparent conductor (material) is to be formed may be subjected to a heat treatment under vacuum or atmospheric pressure, or may be subjected to a plasma treatment or an ultraviolet irradiation treatment before forming the transparent conductive layer.

The thickness of the transparent conductive layer is determined depending on the application, but is normally 10 nm to 5 $\mu$m, preferably 20 to 1000 nm, and more preferably 20 to 500 nm.

The conductive layer may optionally be patterned. The conductive layer may be patterned by chemical etching (e.g., photolithography), physical etching using a laser or the like, vacuum deposition using a mask, sputtering, a lift-off method, printing, or the like.

Transparent conductive film

The transparent conductive film according to one embodiment of the invention includes the base layer, the gas barrier layer, and the transparent conductive layer.

The transparent conductive film according to one embodiment of the invention may include one base layer, one gas barrier layer, and one transparent conductive layer, or may include a plurality of base layers, a plurality of gas barrier layers, and/or a plurality of transparent conductive layers, or may further include an additional layer.

The base layer, the gas barrier layer, and the transparent conductive layer included in the transparent conductive film according to one embodiment of the invention may be stacked in an arbitrary order.

FIG. 1 illustrates an example of the layer configuration of the conductive film according to one embodiment of the invention.

In FIG. 1, reference sign S indicates the base layer, reference sign a indicates the gas barrier layer, and reference sign b indicates the conductive layer.

In FIG 1, (a) indicates a three-layer configuration that sequentially includes the base layer, the gas barrier layer, and the conductive layer, and (b) indicates a three-layer configuration that sequentially includes the conductive layer, the base layer, and the gas barrier layer. It is preferable that the transparent conductive film according to one embodiment of the invention have the layer configuration indicated by (a) in FIG. 1 since the transparent conductive film can be easily produced.

When the transparent conductive film according to one embodiment of the invention includes an additional layer, the additional layer may be a single layer, or may include a plurality of identical or different layers. The additional layer may be situated at an arbitrary position. The position of the additional layer may be determined depending on the function and the like of the additional layer.

Examples of the additional layer include a hard coat layer, an inorganic compound layer, an impact-absorbing layer, a primer layer, and the like.

The hard coat layer is provided to prevent a situation in which the surface of the transparent conductive film is damaged. A material for forming the hard coat layer is not particularly limited. Examples of the material for forming the hard coat layer include energy ray-curable resins, heat-curable resins, and the like.

The thickness of the hard coat layer is normally 0.1 to 20 $\mu$m, and preferably 1 to 10 $\mu$m.

The inorganic compound layer is formed of (includes) one or more inorganic compounds. Examples of the inorganic compounds include inorganic compounds that can be deposited under vacuum, and exhibit a gas barrier capability, such as inorganic oxides, inorganic nitrides, inorganic carbides, inorganic sulfides, and composites thereof (e.g., inorganic oxynitride, inorganic oxycarbide, inorganic carbonitride, and inorganic oxycarbonitride).

The thickness of the inorganic compound layer is normally 10 to 1000 nm, preferably 20 to 500 nm, and more preferably 20 to 100 nm.

The impact-absorbing layer protects the gas barrier layer when an impact is applied to the gas barrier layer. A material for forming the impact-absorbing layer is not particularly limited. Examples of the material for forming the impact-absorbing layer include acrylic resins, urethane resins, silicone resins, olefin resins, rubber materials, and the like.

A product commercially available as a pressure-sensitive adhesive, a coating material, a sealing material, or the like may also be used as the material for forming the impact-absorbing layer. It is preferable to use a pressure-sensitive adhesive (e.g., acrylic pressure-sensitive adhesive, silicone pressure-sensitive adhesive, or rubber pressure-sensitive adhesive).

The impact-absorbing layer may be formed by an arbitrary method. For example, the impact-absorbing layer may be formed by applying a solution that includes the material (e.g., pressure-sensitive adhesive) for forming the impact-absorbing layer and an optional component (e.g., solvent) to the layer on which the impact-absorbing layer is to be formed, drying the resulting film, and optionally heating the dried film.

Alternatively, the impact-absorbing layer may be formed on a release base, and transferred to the layer on which the impact-absorbing layer is to be formed.

The thickness of the impact-absorbing layer is normally 1 to 100 $\mu$m, and preferably 5 to 50 $\mu$m.

The primer layer improves interlayer adhesion between the base layer and the gas barrier layer or the transparent conductive layer. A transparent conductive film that exhibits excellent interlayer adhesion and surface flatness (i.e., the surface of the base can be planarized) can be obtained by providing the primer layer.

An arbitrary known material may be used to form the primer layer. Examples of the material that may be used to form the primer layer include silicon-containing compounds; a photopolymerizable composition that includes a photopolymerizable compound formed of a photopolymerizable monomer and/or a photopolymerizable prepolymer, and an initiator that generates radicals at least due to visible light or UV rays; resins such as a polyester resin, a polyurethane resin (particularly a two-component curable resin that includes an isocyanate compound and a polyacryl polyol, a polyester polyol, a polyether polyol, or the like), an acrylic resin, a polycarbonate resin, a vinyl chloride/vinyl acetate copolymer, a polyvinyl butyral resin, and a nitrocellulose resin; alkyl titanates; ethyleneimine; and the like. These materials may be used either alone or in combination.

The primer layer may be formed by dissolving or dispersing the material for forming the primer layer in an appropriate solvent to prepare a primer layer-forming solution, applying the primer layer-forming solution to one side or each side of the base layer, drying the resulting film, and optionally heating the dried film.

The primer layer-forming solution may be applied to the base layer by a normal wet coating method. Examples of the wet coating method include dipping, roll coating, gravure coating, knife coating, air knife coating, roll knife coating, die coating, screen printing, spray coating, a gravure offset method, and the like.

The film formed by applying the primer layer-forming solution may be dried by hot-air drying, heat roll drying, infrared irradiation, or the like. The thickness of the primer layer is normally 10 to 1000 nm.

Ions may be implanted into the primer layer in the same manner as in the case of forming the ion-implanted layer (described later). A transparent conductive film that exhibits a more excellent gas barrier capability can be obtained by implanting ions into the primer layer.

When the transparent conductive film according to one embodiment of the invention includes the additional layer, the layers may be stacked in an arbitrary order.

The thickness of the transparent conductive film according to one embodiment of the invention is not particularly limited, and may be appropriately determined depending on the application of the resulting electronic device and the like. The thickness of the transparent conductive film is normally 1 to 1000 μm.

The transparent conductive film according to one embodiment of the invention exhibits an excellent gas barrier capability and excellent transparency, and has low sheet resistance (i.e., exhibits excellent conductivity) even under a high-temperature/high-humidity environment.

The transparent conductive film according to one embodiment of the invention exhibits an excellent gas barrier capability since the transparent conductive film has a low gas (e.g., water vapor) transmission rate. For example, the water vapor transmission rate of the transparent conductive film at a temperature of 40°C and a relative humidity of 90% is 6.0 g/m$^2$/day or less, and preferably 1.5 g/m$^2$/day or less. The gas (e.g., water vapor) transmission rate of the transparent conductive film may be measured using a known gas transmission rate measurement system.

The transparent conductive film according to one embodiment of the invention exhibits excellent transparency since the transparent conductive film has high visible light transmittance. The visible light transmittance (wavelength: 550 nm) of the transparent conductive film according to one embodiment of the invention is 90% or more. The visible light transmittance of the transparent conductive film may be measured using a known visible light transmittance measurement system.

The transparent conductive film according to one embodiment of the invention exhibits excellent conductivity since the transparent conductive film has low sheet resistance (surface resistivity). The sheet resistance (surface resistivity) of the transparent conductive film according to one embodiment of the invention is normally 1000 Ω/square or less, and preferably 550 Ω/square or less. The sheet resistance of the transparent conductive film may be measured by a known method.

The transparent conductive film according to one embodiment of the invention has low sheet resistance (i.e., exhibits excellent conductivity) even under a high-temperature/high-humidity environment since the transparent conductive film has small sheet resistance change rates T1 and T2 (see below), for example.

[Expression 1]

$$T1 = (R1 - R0) / R0$$
$$T2 = (R2 - R0) / R0$$

where, R0 is the initial sheet resistance of the transparent conductive film, R1 is the sheet resistance of the transparent conductive film after the transparent conductive film has been allowed to stand at 60°C for 3 days, and R2 is the sheet resistance of the transparent conductive film after the transparent conductive film has been allowed to stand at 60°C and 90%RH for 3 days.

The sheet resistance change rate T1 of the transparent conductive film according to one embodiment of the invention is normally less than 1.0, preferably 0.5 or less, and more preferably 0.1 or less, and the sheet resistance change rate T2 of the transparent conductive film according to one embodiment of the invention is normally 1.0 or less, preferably 0.5 or less, and more preferably 0.35 or less.

2) Method for producing transparent conductive film

A method for producing a transparent conductive film according to one embodiment of the invention includes implanting ions into a layer (silicate layer) that forms the surface of a formed body and includes a hydrolysis/dehydration condensation product of a tetrafunctional organosilane compound.

The method for producing a transparent conductive film according to one embodiment of the invention can easily and efficiently produce the transparent conductive film according to one embodiment of the invention.

The ions mentioned above in connection with the transparent conductive film (see "1) Transparent conductive film") are preferable as the ions used for the method for producing a transparent conductive film according to one embodiment of the invention. It is preferable to implant the ions by a plasma ion implantation method.

The plasma ion implantation method includes applying a negative high-voltage pulse to a formed body that includes a surface polymer layer and is exposed to plasma, to implant ions present in the plasma into the surface area of the polymer layer.

It is preferable to use (A) a plasma ion implantation method that implants ions present in plasma generated by utilizing an external electric field into the surface area of the silicate layer, or (B) a plasma ion implantation method that implants ions present in plasma generated due to an electric field produced by applying a negative high-voltage pulse to the silicate layer into the surface area of the silicate layer.

When using the method (A), it is preferable to set the ion implantation pressure (plasma ion implantation pressure) to 0.01 to 1 Pa. When the plasma ion implantation pressure is within the above range, a uniform ion-implanted layer can be formed easily and efficiently. This makes it possible to efficiently form an ion-implanted layer that exhibits transparency and a gas barrier capability in combination.

The method (B) does not require increasing the degree of decompression, allows a simple operation, and significantly reduces the processing time. Moreover, the entire polymer layer can be uniformly processed, and ions present in the plasma can be continuously implanted into the surface area of the silicate layer with high energy by applying a negative high-voltage pulse. The method (B) also has an advantage in that ions can be uniformly implanted into the surface area of the silicate layer by merely applying a negative high-voltage pulse to the silicate layer without requiring a special means such as a high-frequency power supply (e.g., radio frequency (RF) power supply or microwave power supply).

When using the method (A) or (B), the pulse width when applying a negative high-voltage pulse (i.e., during ion implantation) is preferably 1 to 15 $\mu$s. If the pulse width is within the above range, uniform ion implantation can be performed more easily and efficiently.

The voltage applied when generating plasma is preferably -1 to -50 kV, more preferably -1 to -30 kV, and particularly preferably -5 to -20 kV. If the applied voltage is higher than -1 kV, the dose may be insufficient, and the desired performance may not be obtained. If the applied voltage is lower than -50 kV, the formed article may be electrically charged during ion implantation, or the formed article may be colored, for example.

The ion species used for plasma ion implantation is the same as described above. It is preferable to use ions of hydrogen, nitrogen, oxygen, argon, helium, neon, xenon, or krypton due to ease of ion implantation and a capability to form a formed article that exhibits excellent transparency and an excellent gas barrier capability. It is more preferable to use ions of nitrogen, oxygen, argon, or helium.

A plasma ion implantation apparatus is used when implanting ions present in plasma into the surface area of the silicate layer.

Specific examples of the plasma ion implantation apparatus include ($\alpha$) a system that causes the polymer layer (hereinafter may be referred to as "ion implantation target layer") to be evenly enclosed by plasma by superimposing high-frequency electric power on a feed-through that applies a negative high-voltage pulse to the ion implantation target layer so that ions present in the plasma are attracted to and collide with the target, and thereby implanted and deposited therein (JP-A-2001-26887), ($\beta$) a system that includes an antenna in a chamber, wherein high-frequency electric power is applied to generate plasma, and positive and negative pulses are alternately applied to the ion implantation target layer after the plasma has reached an area around the ion implantation target layer, so that ions present in the plasma are attracted to and implanted into the target while heating the ion implantation target layer, causing electrons present in the plasma to be attracted to and collide with the target due to the positive pulse, and applying the negative pulse while controlling the temperature by controlling the pulse factor (JP-A-2001-156013), ($\gamma$) a plasma ion implantation apparatus that generates plasma using an external electric field utilizing a high-frequency electric power supply such as a microwave power supply, and causes ions present in the plasma to be attracted to and implanted into the target by applying a high-voltage pulse, ($\delta$) a plasma ion implantation apparatus that implants ions present in plasma generated due to an electric field produced by applying a high-voltage pulse without using an external electric field, and the like.

It is preferable to use the plasma ion implantation apparatus ($\gamma$) or ($\delta$) since the plasma ion implantation apparatus ($\gamma$) or ($\delta$) allows a simple operation, significantly reduces the processing time, and can be continuously used.

The method disclosed in WO2010/021326 may be used when using the plasma ion implantation apparatus ($\gamma$) or ($\delta$).

Since the plasma ion implantation apparatus ($\gamma$) or ($\delta$) is configured so that the high-voltage pulse power supply also serves as the plasma generation means that generates plasma, it is possible to generate plasma and implant ions into the surface area of the silicate layer by merely applying a negative high-voltage pulse to the silicate layer without requiring a special means such as a high-frequency power supply (e.g., RF power supply or microwave power supply), and continuously form a plasma-implanted layer to mass-produce a transparent conductive film in which the plasma-implanted layer is formed.

It is preferable to implant ions into the surface area of the silicate layer while feeding a long formed body that includes a surface silicate layer in a given direction. This makes it possible to continuously implant ions.

The long formed body may include only the base layer and the silicate layer, or may include an additional layer as long as the silicate layer is formed in its surface area.

The thickness of the formed body is preferably 1 to 500 $\mu$m, and more preferably 5 to 300 $\mu$m, from the viewpoint of winding/unwinding operability and feeding operability.

The transparent conductive film according to one embodiment of the invention in which the base layer, the gas barrier layer, and the transparent conductive layer are sequentially stacked, may be produced as described below.

A silicate layer is formed on one side of a long base (base layer). The silicate layer may be formed by applying the silicate layer-forming solution to one side of the long base using a coater while feeding the long base in a given direction, drying the resulting film, and optionally heating the dried film, for example.

The silicate layer is then subjected to plasma ion implantation using a plasma ion implantation apparatus to obtain a long formed body in which a gas barrier layer is formed on a base layer.

A transparent conductive layer is formed on the gas barrier layer of the long formed body by sputtering.

The transparent conductive film according to one embodiment of the invention can thus be obtained.

The transparent conductive film according to one embodiment of the invention can be easily produced by the above method for producing a transparent conductive film according to one embodiment of the invention.

3) Electronic device member and electronic device

An electronic device member according to one embodiment of the invention includes the transparent conductive film according to one embodiment of the invention. Therefore, the electronic device member according to one embodiment of the invention exhibits an excellent gas barrier capability, and does not show a deterioration in an element (member or device) due to gas (e.g., water vapor). Since the electronic device member exhibits high light transmittance, and has low sheet resistance (i.e., exhibits excellent conductivity) even under a high-temperature/high-humidity environment, the electronic device member may suitably be used for electronic devices such as a display (e.g., liquid crystal display and EL display) and a solar cell.

An electronic device according to one embodiment of the invention includes the electronic device member according to one embodiment of the invention. Specific examples of the electronic device include a liquid crystal display, an organic EL display, an inorganic EL display, electronic paper, a solar cell, and the like.

Since the electronic device according to one embodiment of the invention includes the electronic device member that includes the transparent conductive film according to one embodiment of the invention, the electronic device exhibits an excellent gas barrier capability, excellent transparency, and excellent conductivity.

EXAMPLES

The invention is further described below by way of examples.

The following plasma ion implantation apparatus, water vapor transmission rate measurement system, visible light transmittance measurement system, sheet resistance measurement system, and XPS elemental analysis system of surface layer part of gas barrier layer (ion-implanted layer) were used, and the following water vapor transmission rate measurement conditions and humidity and heat test method were adopted in the examples.

Plasma ion implantation apparatus

RF power supply: "RF56000" manufactured by JEOL Ltd.
High-voltage pulsed power supply: "PV-3-HSHV-0835" manufactured by Kurita Seisakusho Co., Ltd.

Note that an apparatus that implants ions using an external electric field was used as the plasma ion implantation apparatus.

Water vapor transmission rate measurement system and conditions

The water vapor transmission rate of the transparent conductive film was measured at a temperature of 40°C and a relative humidity of 90% using the following measurement system.
Water vapor transmission rate measurement system: "PERMATRAN" manufactured by Mocon

Visible light transmittance measurement system

The visible light transmittance was measured at a wavelength of 550 nm using the following measurement system.
Visible light transmittance measurement system: "UV-3101PC" manufactured by Shimadzu Corporation

Sheet resistance measurement system

The sheet resistance of the transparent conductive film was determined by measuring the surface resistivity of the transparent conductive layer at a temperature of 23°C and a relative humidity of 50% using the following measurement system. A probe "PROBE TYPE LSP" (manufactured by Mitsubishi Chemical Analytech Co., Ltd.) was used for the measurement.

Sheet resistance measurement system: "LORESTA-GP MCP-T600" manufactured by Mitsubishi Chemical Corporation

Humidity and heat test method

The transparent conductive film was allowed to stand at 60°C for 3 days or at 60°C and 90%RH for 3 days. After conditioning the transparent conductive film at 23°C and 50%RH for 1 day, the sheet resistance of the transparent conductive film was measured by the above method.

The sheet resistance change rates T1 and T2 were calculated by the following expression.

Note that R0 is the initial sheet resistance of the transparent conductive film, R1 is the sheet resistance of the transparent conductive film after the transparent conductive film had been allowed to stand at 60°C for 3 days, and R2 is the sheet resistance of the transparent conductive film after the transparent conductive film had been allowed to stand at 60°C and 90%RH for 3 days. The sign "RH" indicates relative humidity.

[Expression 2]

$$T1 = (R1 - R0) / R0$$
$$T2 = (R2 - R0) / R0$$

XPS elemental analysis system of surface layer part of gas barrier layer (ion-implanted layer)

XPS (X-ray photoelectron spectroscopy) elemental analysis was performed using the following measurement system under the following measurement conditions. The transparent conductive layer of the transparent conductive film was removed by sputtering to expose the interface of the gas barrier layer with the transparent conductive layer, and the oxygen atom content rate, the carbon atom content rate, and the silicon atom content rate in the surface layer part of the gas barrier layer were measured.

Measuring system: "PHI Quantera SXM" manufactured by ULVAC-PHI, Incorporated
X-ray source: AlK$\alpha$
X-ray beam diameter: 100 $\mu$m
Electric Power: 25 W
Voltage: 15 kV
Take-off angle: 45°
Degree of vacuum: $5.0 \times 10^{-8}$ Pa
Sputtering conditions
Sputtering gas: argon
Applied voltage: -4 kV

Example 1

A silicate coating liquid ("Colcoat N103-X" manufactured by Colcoat Co., Ltd., weight average molecular weight of silicate: 1000 to 10,000) (hydrolysis/dehydration condensation compound of tetraethoxysilane) (hereinafter referred to as "silicate coating liquid A") was applied to a polyethylene terephthalate film ("PET188 A-4300" manufactured by Toyobo Co., Ltd., thickness: 188 $\mu$m) (base layer) (hereinafter referred to as "PET film"), and dried to form a silicate layer (thickness: 75 nm). A formed body was thus obtained.

Argon (Ar) ions were implanted into the surface of the silicate layer of the formed body under the following conditions using a plasma ion implantation apparatus.

Plasma ion implantation conditions
Plasma-generating gas: argon
Gas flow rate: 100 sccm
Duty ratio: 1.0%
Repetition frequency: 1000 Hz
Applied voltage: -15 kV

RF power supply: frequency: 13.56 MHz, applied electric power: 1000 W
Chamber internal pressure: 0.2 Pa
Pulse width: 5 $\mu$s
Processing time (ion implantation time): 5 min
Line (feed) speed: 0.2 m/min

A transparent conductive layer (thickness: 100 nm) was formed on the ion-implanted side of the formed body by DC magnetron sputtering using a zinc oxide target material containing 5.7 mass% of $Ga_2O_3$ (manufactured by Sumitomo Metal Mining Co., Ltd.) to obtain a transparent conductive film 1.
The sputtering conditions are shown below.

Substrate temperature: room temperature
DC output: 500 W
Carrier gas: argon and oxygen (flow rate ratio: 100:0 to 100:3)
Degree of vacuum: 0.3 to 0.8 Pa

Example 2

A transparent conductive film 2 was obtained in the same manner as in Example 1, except that helium (He) was used as the plasma-generating gas instead of argon.

Example 3

A transparent conductive film 3 was obtained in the same manner as in Example 1, except that krypton (Kr) was used as the plasma-generating gas instead of argon.

Example 4

A transparent conductive film 4 was obtained in the same manner as in Example 1, except that nitrogen ($N_2$) was used as the plasma-generating gas instead of argon.

Example 5

A transparent conductive film 5 was obtained in the same manner as in Example 1, except that oxygen ($O_2$) was used as the plasma-generating gas instead of argon.

Example 6

A transparent conductive film 6 was obtained in the same manner as in Example 1, except that the applied voltage was changed to -10 kV.

Example 7

A transparent conductive film 7 was obtained in the same manner as in Example 1, except that the applied voltage was changed to -20 kV.

Example 8

A transparent conductive film 8 was obtained in the same manner as in Example 1, except that a silicate coating liquid ("Colcoat PX" manufactured by Colcoat Co., Ltd., weight average molecular weight of silicate: 20,000 to 30,000) (hydrolysis/dehydration condensation compound of tetraethoxysilane) (hereinafter referred to as "silicate coating liquid B") was used instead of the silicate coating liquid A.

Comparative Example 1

A transparent conductive layer was formed directly on the PET film in the same manner as in Example 1 to obtain a transparent conductive film 1r.

Comparative Example 2

A transparent conductive film 2r was obtained in the same manner as in Example 1, except that plasma ion implantation was not performed.

Comparative Example 3

A transparent conductive film 3r was obtained in the same manner as in Example 8, except that plasma ion implantation was not performed.

Comparative Example 4

An $SiO_2$ film (thickness: 50 nm) was formed on the PET film by sputtering to obtain a transparent conductive film 4r.

Comparative Example 5

A formed body was obtained in the same manner as in Example 1, except that a polyorganosiloxane compound silicone release agent ("KS835" manufactured by Shin-Etsu Chemical Co., Ltd. (silicone resin containing polydimethylsiloxane as the main component)) (hereinafter referred to as "coating liquid D") was used instead of the silicate coating liquid A. Plasma ion implantation was then performed in the same manner as in Example 6 to obtain a transparent conductive film 5r.

Comparative Example 6

A formed body was obtained in the same manner as in Example 1, except that a polyorganosiloxane compound obtained by mixing 3.97 g (20 mmol) of phenyltrimethoxysilane (manufactured by Tokyo Kasei Kogyo Co., Ltd.), 4.73 g (20 mmol) of 3-glycidoxypropyltrimethoxysilane (manufactured by Tokyo Kasei Kogyo Co., Ltd.), 20 ml of toluene, 10 ml of distilled water, and 0.10 g (1 mol) of phosphoric acid (manufactured by Kanto Chemical Co., Ltd.), and reacting the components at room temperature for 24 hours (hereinafter referred to as "coating liquid E"), was used instead of the silicate coating liquid A. Plasma ion implantation was then performed in the same manner as in Example 6 to obtain a transparent conductive film 6r.
The type of the silicate layer, the ion implantation gas, and the applied voltage during ion implantation used when forming the transparent conductive films 1 to 8 of Examples 1 to 8 and the transparent conductive films 1r to 6r of Comparative Examples 1 to 6 are shown in Table 1. The meanings of the signs A to E in Table 1 are shown below.
The silicon atom content rate, the oxygen atom content rate, and the carbon atom content rate in the surface layer part of the gas barrier layer were also measured. The results are shown in Table 1.
A: silicate layer formed using silicate coating liquid A

B: silicate layer formed using silicate coating liquid B

C: $SiO_2$ film formed by sputtering

D: polysiloxane layer formed using coating liquid D

E: polysiloxane layer formed using coating liquid E

TABLE 1

| | Gas barrier layer | | | Content rate in surface layer part of gas barrier layer | | |
|---|---|---|---|---|---|---|
| | Type | Ion implantation gas | Applied voltage (-kV) | Silicon atom (%) | Oxygen atom (%) | Carbon atom (%) |
| Example 1 | A | Ar | 15 | 22.25 | 60.30 | 15.85 |
| Example 2 | A | He | 15 | 22.71 | 59.64 | 17.65 |
| Example 3 | A | Kr | 15 | 21.64 | 56.78 | 21.58 |
| Example 4 | A | $N_2$ | 15 | 21.49 | 50.82 | 27.69 |
| Example 5 | A | $O_2$ | 15 | 22.79 | 59.78 | 17.42 |
| Example 6 | A | Ar | 10 | 23.82 | 63.26 | 12.39 |
| Example 7 | A | Ar | 20 | 19.06 | 59.69 | 19.53 |
| Example 8 | B | Ar | 15 | 25.04 | 61.31 | 13.64 |
| Comparative Example 1 | - | - | - | - | - | - |
| Comparative Example 2 | A | - | - | 24.61 | 63.38 | 11.85 |
| Comparative Example 3 | B | - | - | 23.78 | 61.20 | 15.02 |
| Comparative Example 4 | C | - | - | 65.68 | 33.11 | 1.21 |
| Comparative Example 5 | D | Ar | 10 | 23.00 | 56.40 | 20.60 |
| Comparative Example 6 | E | Ar | 10 | 19.50 | 45.50 | 35.50 |

The water vapor transmission rate, the visible light transmittance (wavelength: 550 nm), and the sheet resistance (R0) of the transparent conductive films 1 to 8 obtained in Examples 1 to 8 and the transparent conductive films 1r to 6r obtained in Comparative Examples 1 to 6 were measured. The measurement results are shown in Table 2.
After subjecting the transparent conductive films to the humidity and heat test, the sheet resistances R1 and R2 were measured, and the sheet resistance change rates T1 and T2 were calculated. The results are shown in Table 2.

TABLE 2

| | Transparent conductive film | Water vapor transmission rate (g/cm$^2$/day) | Visible light transmittance (%) | Sheet resistance ($\Omega$/square) | | | | |
|---|---|---|---|---|---|---|---|---|
| | | | | Initial value (R0) | 60°C (after 3 days) (R1) | 60°C, 90%RH (after 3 days) (R2) | T1 | T2 |
| Example 1 | 1 | 0.17 | 91.3 | 515 | 520 | 525 | 0.01 | 0.02 |
| Example 2 | 2 | 1.07 | 90.1 | 520 | 520 | 600 | 0.00 | 0.15 |
| Example 3 | 3 | 1.34 | 91.9 | 530 | 530 | 620 | 0.00 | 0.17 |
| Example 4 | 4 | 1.21 | 90.2 | 520 | 530 | 560 | 0.02 | 0.08 |
| Example 5 | 5 | 0.98 | 90.3 | 495 | 500 | 600 | 0.01 | 0.21 |
| Example 6 | 6 | 0.65 | 91.3 | 500 | 510 | 520 | 0.02 | 0.04 |
| Example 7 | 7 | 0.38 | 90.9 | 515 | 515 | 520 | 0.00 | 0.01 |

(continued)

| | Transparent conductive film | Water vapor transmission rate (g/cm$^2$/day) | Visible light transmittance (%) | Sheet resistance ($\Omega$/square) | | | | |
|---|---|---|---|---|---|---|---|---|
| | | | | Initial value (R0) | 60°C (after 3 days) (R1) | 60°C, 90%RH (after 3 days) (R2) | T1 | T2 |
| Example 8 | 8 | 5.22 | 91.7 | 515 | 515 | 680 | 0.00 | 0.32 |
| Comparative Example 1 | 1r | 9.12 | 89.7 | 510 | 3000 | 25000 | 4.88 | 48.02 |
| Comparative Example 2 | 2r | 9.05 | 923 | 490 | 3400 | 10000 | 5.94 | 19.41 |
| Comparative Example 3 | 3r | 9.38 | 92.4 | 500 | 2800 | 22000 | 4.60 | 43.00 |
| Comparative Example 4 | 4r | 0.52 | 91.5 | 500 | 1000 | 28000 | 1.00 | 55.00 |
| Comparative Example 5 | 5r | 1.13 | 86.7 | 490 | 490 | 620 | 0.00 | 0.27 |
| Comparative Example 6 | 6r | 1.20 | 86.3 | 520 | 520 | 690 | 0.00 | 0.33 |

As shown in Table 2, the transparent conductive films 1 to 8 obtained in Examples 1 to 8 had a low water vapor transmission rate (i.e., exhibited an excellent gas barrier capability). The transparent conductive films 1 to 8 had high visible light transmittance (wavelength: 550 nm) (i.e., 90% or more) and low sheet resistance (i.e., exhibited excellent transparency and conductivity).

The transparent conductive films 1 to 8 obtained in Examples subjected to the humidity and heat test had small sheet resistance change rates T1 and T2 (0.02 or less and 0.32 or less, respectively) as compared with the transparent conductive films 1r to 4r obtained in Comparative Examples 1 to 4. Therefore, it was confirmed that an increase in sheet resistance could be suppressed even under a high-temperature/high-humidity environment. The transparent conductive films 1 to 8 obtained in Examples 1 to 8 had a high visible light transmittance (wavelength: 550 nm) (i.e., exhibited excellent transparency) as compared with the transparent conductive films 5r and 6r obtained in Comparative Examples 5 and 6.

REFERENCE SIGNS LIST

a    Gas barrier layer
b    Conductive layer
S    Base layer

**Claims**

1. A transparent conductive film comprising a base layer, a gas barrier layer, and a transparent conductive layer,
   the gas barrier layer being formed of a material that includes silicon atoms, oxygen atoms, and carbon atoms, a silicon atom content rate, an oxygen atom content rate, and a carbon atom content rate in a surface layer part of the gas barrier layer determined by XPS elemental analysis being 18.0 to 28.0%, 48.0 to 66.0%, and 10.0 to 28.0%, respectively, based on a total content rate (=100 atom%) of silicon atoms, oxygen atoms, and carbon atoms, wherein the gas barrier layer is a layer obtained by implanting ions into a layer that includes a hydrolysis/dehydration condensation product of a tetrafunctional organosilane compound, and
   the transparent conductive film having a water vapor transmission rate at a temperature of 40°C and a relative humidity of 90% of 6.0 g/m$^2$/day or less, and a visible light transmittance at a wavelength of 550 nm of 90% or more.

**2.** The transparent conductive film according to claim 1, wherein the ions are obtained by ionizing at least one gas selected from a group consisting of hydrogen, oxygen, nitrogen, argon, helium, xenon, krypton, a silicon compound, and a hydrocarbon.

**3.** The transparent conductive film according to claim 1, wherein the gas barrier layer is a layer obtained by implanting ions into a layer that includes a hydrolysis/dehydration condensation product of a tetrafunctional organosilane compound by a plasma ion implantation method.

**4.** The transparent conductive film according to any one of claims 1 to 3, wherein the tetrafunctional organosilane compound is a tetra($C_1$-$C_{10}$)alkoxysilane.

**5.** The transparent conductive film according to claim 1, wherein the transparent conductive layer is formed of a conductive metal oxide.

**6.** The transparent conductive film according to claim 5, wherein the conductive metal oxide is a zinc-based oxide.

**7.** A method for producing the transparent conductive film according to any one of claims 1 to 6, the method comprising implanting ions into a layer that forms a surface of a formed body and includes a hydrolysis/dehydration condensation product of a tetrafunctional organosilane compound.

**8.** The method according to claim 7, wherein the ions are obtained by ionizing at least one gas selected from a group consisting of hydrogen, oxygen, nitrogen, argon, helium, xenon, krypton, a silicon compound, and a hydrocarbon.

**9.** The method according to claim 7, wherein the ions are implanted by a plasma ion implantation method.

**10.** An electronic device member comprising the transparent conductive film according to any one of claims 1 to 6.

**11.** An electronic device comprising the electronic device member according to claim 10.


**Patentansprüche**

**1.** Transparenter leitender Film, der einer Basisschicht, eine Gasbarriereschicht und eine transparente leitende Schicht umfasst,
wobei die Gasbarriereschicht aus einem Material, das Siliciumatome, Sauerstoffatome und Kohlenstoffatome umfasst, gebildet ist, ein Siliciumatomgehaltsanteil, ein Sauerstoffatomgehaltsanteil und ein Kohlenstoffatomgehaltsanteil in einem Oberflächenschichtteil der Gasbarriereschicht, bestimmt durch XPS-Elementanalyse, 18,0 bis 28,0%, 48,0 bis 66,0% bzw. 10,0 bis 28,0% beträgt, basierend auf einem Gesamtgehaltsanteil (=100 Atom%) an Siliciumatomen, Sauerstoffatomen und Kohlenstoffatomen, wobei die Gasbarriereschicht eine Schicht ist, die durch Implantieren von Ionen in eine Schicht, die ein Hydrolyse/Dehydratisierungs-Kondensationsprodukt einer tetrafunktionellen Organosilanverbindung umfasst, erhalten wurde, und
wobei der transparente leitende Film eine Wasserdampftransmissionsrate bei einer Temperatur von 40°C und einer relativen Feuchtigkeit von 90% von 6,0 g/m$^2$/Tag oder weniger und einen Transmissionsgrad des sichtbaren Lichts mit einer Wellenlänge von 550 nm von 90% oder mehr hat.

**2.** Transparenter leitender Film gemäß Anspruch 1, wobei die Ionen durch Ionisieren wenigstens eines Gases, ausgewählt aus der Gruppe, bestehend aus Wasserstoff, Sauerstoff, Stickstoff, Argon, Helium, Xenon, Krypton, einer Siliciumverbindung und einem Kohlenwasserstoff, erhalten wurden.

**3.** Transparenter leitender Film gemäß Anspruch 1, wobei die Gasbarriereschicht eine Schicht ist, die durch Implantieren von Ionen in eine Schicht, die ein Hydrolyse/Dehydratisierungs-Kondensationsprodukt einer tetrafunktionellen Organosilanverbindung umfasst, durch ein Plasmaionenimplantationsverfahren erhalten wurde.

**4.** Transparenter leitender Film gemäß einem der Ansprüche 1 bis 3, wobei die tetrafunktionelle Organosilanverbindung ein Tetra ($C_1$-$C_{10}$) alkoxysilan ist.

**5.** Transparenter leitender Film gemäß Anspruch 1, wobei die transparente leitende Schicht aus einem leitenden Metalloxid gebildet ist.

**6.** Transparenter leitender Film gemäß Anspruch 5, wobei das leitende Metalloxid ein zinkbasiertes Oxid ist.

**7.** Verfahren zur Herstellung des transparenten leitenden Films gemäß einem der Ansprüche 1 bis 6, wobei das Verfahren Implantieren von Ionen in eine Schicht, die eine Oberfläche eines geformten Körpers formt und ein Hydrolyse/Dehydratisierungs-Kondensationsprodukt einer tetrafunktionellen Organosilanverbindung umfasst, umfasst.

**8.** Verfahren gemäß Anspruch 7, wobei die Ionen durch Ionisieren wenigstens eines Gases, ausgewählt aus einer Gruppe, bestehend aus Wasserstoff, Sauerstoff, Stickstoff, Argon, Helium, Xenon, Krypton, einer Siliciumverbindung und einem Kohlenwasserstoff, erhalten werden.

**9.** Verfahren gemäß Anspruch 7, wobei die Ionen durch ein Plasmaionenimplantationsverfahren implantiert werden.

**10.** Element für eine elektronische Vorrichtung, das den transparenten leitenden Film gemäß einem der Ansprüche 1 bis 6 umfasst.

**11.** Elektronische Vorrichtung, die das Element für eine elektronische Vorrichtung gemäß Anspruch 10 umfasst.

**Revendications**

**1.** Film conducteur transparent comprenant une couche de base, une couche de barrière au gaz, et une couche conductrice transparente,
la couche de barrière au gaz étant formée d'un matériau qui comporte des atomes de silicium, des atomes d'oxygène, et des atomes de carbone, un taux de teneur en atome de silicium, un taux de teneur en atome d'oxygène, et un taux de teneur en atome de carbone dans une partie de couche de surface de la couche de barrière au gaz déterminés par analyse élémentaire XPS étant de 18,0 à 28,0 %, de 48,0 à 66,0 %, et de 10,0 à 28,0 %, respectivement, d'après un taux de teneur total (= 100 % atomique) en atomes de silicium, atomes d'oxygène, et atomes de carbone, dans lequel la couche de barrière au gaz est une couche obtenue en implantant des ions dans une couche qui comporte un produit de condensation d'hydrolyse/déshydratation d'un composé organosilane tétrafonctionnel, et
le film conducteur transparent ayant un taux de transmission de vapeur d'eau à une température de 40 °C et une humidité relative de 90 % de 6,0 g/m$^2$/jour ou moins, et une transmittance de la lumière visible à une longueur d'onde de 550 nm de 90 % ou plus.

**2.** Film conducteur transparent selon la revendication 1, dans lequel les ions sont obtenus en ionisant au moins un gaz choisi dans un groupe consistant en l'hydrogène, l'oxygène, l'azote, l'argon, l'hélium, le xénon, le crypton, un composé silicium, et un hydrocarbure.

**3.** Film conducteur transparent selon la revendication 1, dans lequel la couche de barrière au gaz est une couche obtenue en implantant des ions dans une couche qui comporte un produit de condensation d'hydrolyse/déshydratation d'un composé organosilane tétrafonctionnel par un procédé d'implantation ionique au plasma.

**4.** Film conducteur transparent selon l'une quelconque des revendications 1 à 3, dans lequel le composé organosilane tétrafonctionnel est un tétraalcoxysilane en $C_1$ à $C_{10}$.

**5.** Film conducteur transparent selon la revendication 1, dans lequel la couche conductrice transparente est formée d'un oxyde de métal conducteur.

**6.** Film conducteur transparent selon la revendication 5, dans lequel l'oxyde de métal conducteur est un oxyde à base de zinc.

**7.** Procédé de production du film conducteur transparent selon l'une quelconque des revendications 1 à 6, le procédé comprenant l'implantation d'ions dans une couche qui forme une surface d'un corps formé et comporte un produit de condensation d'hydrolyse/déshydratation d'un composé organosilane tétrafonctionnel.

**8.** Procédé selon la revendication 7, dans lequel les ions sont obtenus en ionisant au moins un gaz choisi dans un groupe consistant en l'hydrogène, l'oxygène, l'azote, l'argon, l'hélium, le xénon, le crypton, un composé silicium, et un hydrocarbure.

9.  Procédé selon la revendication 7, dans lequel les ions sont implantés par un procédé d'implantation ionique au plasma.

10. Organe de dispositif électronique comprenant le film conducteur transparent selon l'une quelconque des revendications 1 à 6.

11. Dispositif électronique comprenant l'organe de dispositif électronique selon la revendication 10.

FIG.1

(a)

b
a
S

(b)

b
S
a

**EP 2 629 307 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2000338901 A
- JP 8045352 A
- JP 6187833 A
- JP 2009199812 A
- JP 2001026887 A
- JP 2001156013 A
- WO 2010021326 A

### Non-patent literature cited in the description

- *APPLIED PHYSICS LETTERS,* 2006, vol. 89, 091904